(19) Europäisches Patentamt
European Patent Office
Office européen des brevets

(11) **EP 4 560 908 A1**

(12) **EUROPEAN PATENT APPLICATION**

(43) Date of publication:
**28.05.2025 Bulletin 2025/22**

(21) Application number: **24212295.0**

(22) Date of filing: **12.11.2024**

(51) International Patent Classification (IPC):
**H02M 3/158** $^{(2006.01)}$

(52) Cooperative Patent Classification (CPC):
**H02M 3/1586; H02M 1/0043**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **22.11.2023   KR 20230162904
05.09.2024   KR 20240120835**

(71) Applicant: **POSTECH Research and Business
Development
Foundation
Pohang-si, Gyeongsangbuk-do 37673 (KR)**

(72) Inventor: **CHAE, Suyong
37673 Pohang-si, Gyeongsangbuk-do (KR)**

(74) Representative: **Jung, Minkyu
Wuesthoff & Wuesthoff
Patentanwälte und Rechtsanwalt PartG mbB
Schweigerstraße 2
81541 München (DE)**

(54) **METHOD AND DEVICE FOR ESTIMATING IMPEDANCE OF CONVERTER OUTPUT ELEMENT**

(57)    Devices and methods for estimating impedance of an output element are described. According to one embodiment, a device for estimating impedance of an output element comprises a data acquisition circuit to acquire measurement data for currents and voltages of the output element connected to a common output node of a first converter module and a second converter module; and an impedance calculation circuit to calculate impedance of the output element using a component corresponding to a switching frequency of the first converter module and a component corresponding to a beat frequency, which corresponds to a difference between the switching frequency of the first converter module and a switching frequency of the second converter module, from current measurement values and voltage measurement values of the output element.

**EP 4 560 908 A1**

**Description**

**CROSS REFERENCE TO RELATED APPLICATION**

This application claims the benefit of and priority to Korea Patent Application No. 10-2023-0162904, filed on November 22, 2023 and Korea Patent Application No. 10-2024-0120835, filed on September 5, 2024, the entire disclosures of which are hereby incorporated herein by reference in its entirety.

**FIELD OF TECHNOLOGY**

The present disclosure relates to a technology for estimating impedance of a converter output device.

**BACKGROUND**

A converter is a device for converting characteristics of electric power. For example, a converter may convert electric power having an alternative current voltage into electric power having a direct current voltage. For another example, a converter may convert electric power having a low voltage level into electric power having a high voltage level.
There are various types of converters, among which buck converters and boost converters are representatively well known.
A buck converter, which is a type of a DC-DC converter, converts an input voltage into an output voltage having a low level. A boost converter, which is also a type of a DC-DC converter, converts an input voltage into an output voltage having a high level.
A converter may comprise various elements. For example, a converter may include switching elements and passive elements. The passive elements may be, for example, inductors, capacitors, resistances, or the like.
A converter repetitively performs a process of storing electric energy in passive elements and discharging the energy by controlling switching elements, and this process enables outputting electric power having changed characteristics.
However, when some of such elements break down or are changed in their characteristics, this converter might not fulfill its function. For example, one of switching elements included in a converter breaks down, the converter cannot normally operate. For another example, the capacitance of a capacitor of a converter is changed, the converter cannot fulfill a desired output specification.
Since a converter is a device supplying electric power to other devices, when a converter breaks down, other devices cannot normally operate. For this reason, many studies are being conducted to prepare for the failure possibility of converters.
For example, studies for observing changes in characteristics of elements included in a converter and predicting the lifespans of the elements depending on changes in characteristics are being conducted. However, since many additional circuits are used to observe the changes in characteristics of elements at a current level of studies, the input costs are high in relation to the risk costs due to failures, leading to an evaluation as having low practicality.
The discussions in this section are intended merely to provide background information and do not constitute an admission of prior art.

**SUMMARY**

In an aspect, embodiments of the present disclosure provide a technology for estimating characteristics of converter elements. In another aspect, embodiments of the present disclosure provide a technology for estimating impedance of converter elements. In another aspect embodiments of the present disclosure provide a technology for estimating impedance a converter output element.
According to an embodiment of the present disclosure, a device for estimating impedance of an output element is provided. The device comprises: a data acquisition circuit to acquire measurement data for currents and voltages of an output element connected to a common output node of a first converter module and a second converter module; and an impedance calculation circuit to calculate impedance of the output element using a component corresponding to a switching frequency of the first converter module and a component corresponding to a beat frequency, which corresponds to a difference between the switching frequency of the first converter module and a switching frequency of the second converter module, from current measurement values and voltage measurement values of the output element.
The impedance calculation circuit may calculate a resistance component of the output element using the component corresponding to the switching frequency of the first converter module and may calculate a reactance component of the output element using the component corresponding to the beat frequency.
The switching frequency of the first converter module and the switching frequency of the second converter module are different from each other, and the difference between them may be equal to or less than 1/10 of the switching frequency of the first converter module.

The impedance calculation circuit may calculate the reactance component using a current/voltage phase angle of the component corresponding to the beat frequency and the pre-calculated resistance component.

The device for estimating impedance of an output element may further include a frequency control circuit capable of transmitting switching frequency control signals to the first converter module and the second converter module. The frequency control circuit may control the switching frequencies of the first converter module and the second converter module to be identical in a first mode and control these switching frequencies to be different in a second mode. The impedance calculation circuit may calculate the reactance component of the output element in the second mode.

The output element may be an output capacitor, and the impedance calculation circuit may calculate a capacitance component of the output capacitor using the beat frequency.

According to another embodiment of the present disclosure, a method for estimating impedance of an output element is provided. The method comprises operations or steps of: acquiring current measurement values and voltage measurement values of an output element connected to a common output node of a first converter module and a second converter module; performing Fast Fourier Transform with respect to the current measurement values and the voltage measurement values; calculating a resistance component of the output element using a component corresponding to a switching frequency of the first converter module from the current measurement values and the voltage measurement values; and calculating a reactance component of the output element using the switching frequency of the first converter module and a component corresponding to a beat frequency, which corresponds to a difference between the switching frequency of the first converter module and a switching frequency of the second converter module, from the current measurement values and the voltage measurement values.

The switching frequency of the first converter module may be higher than the switching frequency of the second converter module.

According to the method, in calculating a resistance component of the output element, in a case when a current/voltage phase angle of the component corresponding to the switching frequency of the first converter module is within a predetermined range, the resistance component of the output element may be calculated.

The first converter module and the second converter module may output inductor currents through the common output node.

According to the method, in calculating a reactance component of the output element of the method, the reactance component may be calculated using the current/voltage phase angle of the component corresponding to the beat frequency and the pre-calculated resistance component.

According to another embodiment of the present disclosure, a method for estimating impedance of an output element. The method comprises operations or steps of: extracting one high-frequency component of current measurement values and one high-frequency component of voltage measurement values by making current measurement signals and voltage measurement signals of an output element, which is connected to a common output node of a first converter module and a second converter module, pass through a high-frequency band pass filter; calculating a resistance component of the output element using the high-frequency components; extracting one low-frequency component of the current measurement values and one low-frequency component of voltage measurement values by making the current measurement signals and voltage measurement signals pass through a low-frequency band pass filter; and calculating a reactance component of the output element using components corresponding to the low-frequency components.

The high-frequency band pass filter may be a band pass filter letting a high-frequency band including a switching frequency of the first converter module pass through.

The low-frequency band pass filter may be a band pass filter letting a low-frequency band including a beat frequency, corresponding to a difference between the switching frequency of the first converter module and a switching frequency of the second converter module, pass through.

According to the method, in calculating a resistance component of the output element, the resistance component may be calculated by dividing the absolute value of a value corresponding to the one high-frequency component of the voltage measurement values by the absolute value of a value corresponding to the one high-frequency component of the current measurement values.

The output element may be an output capacitor and, in calculating a reactance component of the output element, a capacitance component of the output capacitor may be calculated using the beat frequency.

The first converter module and the second converter module may be subjected to interleaving control, and the high-frequency band pass filter may be a band pass filter letting a high-frequency band including a switching frequency formed by the interleaving control, which is N times the original switching frequency (N is equal to or greater than 2), pass through.

According to another embodiment of the present disclosure, a device for estimating impedance of an output element is provided. The device comprises: a data acquisition circuit to acquire measurement data for currents and voltages of an output element connected to a common output node of at least three converter modules; and an impedance calculation circuit to calculate impedance of the output element using at least two components among switching frequency components corresponding to switching frequencies of the respective converter modules and beat frequency components generated by differences between switching frequencies of two or more converter modules from current measurement values and voltage measurement values of the output element.

The impedance calculation circuit may calculate a resistance component of the output element using one of the switching frequency components and calculate a reactance component of the output element using one of the beat frequency components.

The device for estimating impedance of the output element may further include a frequency control circuit capable of transmitting switching frequency control signals to the at least three converter modules. The frequency control circuit may control the switching frequencies of the at least three converter modules to be identical in a first mode and control the switching frequencies of at least two of the at least three converter modules to be different in a second mode. The impedance calculation circuit may calculate the reactance component of the output element in the second mode.

As described above, the present disclosure enables estimating characteristics of converter elements. The present disclosure also enables estimating impedance of converter elements. In addition, the present disclosure enables estimating impedance of a converter output element.

## BRIEF DESCRIPTION OF THE DRAWINGS

In order that the disclosure may be well understood, there are now described various forms thereof, given by way of example, reference being made to the accompanying drawings, in which:

FIG. 1 is a configuration diagram of a converter according to an embodiment;
FIG. 2 is an equivalent circuit diagram of an output element according to an embodiment;
FIG. 3 is a diagram showing waveforms and a phase angle of a voltage and a current flowing into an output element according to an embodiment;
FIG. 4 is a bode diagram of an output element according to an embodiment;
FIG. 5 is a diagram showing beat frequency waveforms shown in an output current of a converter according to an embodiment;
FIG. 6 is a configuration diagram of a device for estimating impedance of an output element of a converter according to an embodiment;
FIG. 7 is a flow diagram of a first example of a method in which a device according to an embodiment estimates impedance of an output element of a converter;
FIG. 8 is a diagram showing simulation results according to a first example;
FIG. 9 is a flow diagram of a second example of a method in which a device according to an embodiment estimates impedance of an output element of a converter;
FIG. 10 is a diagram showing simulation results according to a second example;
FIG. 11 is a configuration diagram of a converter according to another embodiment;
FIG. 12 is a configuration diagram of a device for estimating impedance of an output element of a converter according to another embodiment;
FIG. 13 is a flow diagram of a first example of a method in which a device according to another embodiment estimates impedance of an output element of a converter; and
FIG. 14 is a flow diagram of a second example of a method in which a device according to another embodiment estimates impedance of an output element of a converter.

## DETAILED DESCRIPTION

Hereinafter, some embodiments of the present disclosure are described in detail with reference to the accompanying drawings. With regard to the reference numerals of the components of the respective drawings, it should be noted that the same reference numerals are assigned to the same components even when the components are shown in different drawings. In addition, in describing the present disclosure, detailed descriptions of well-known configurations or functions have been omitted in order to not obscure the gist of the present disclosure.

In addition, terms such as "1st", "2nd", "A", "B", "(a)", "(b)", or the like may be used in describing the components of the present disclosure. These terms are intended only for distinguishing a corresponding component from other components, and the nature, order, or sequence of the corresponding component is not limited to the terms. In the case where a component is described as being "coupled", "combined", or "connected" to another component, it should be understood that the corresponding component may be directly coupled or connected to another component or that the corresponding component may also be "coupled", "combined", or "connected" to the component via another component provided therebetween.

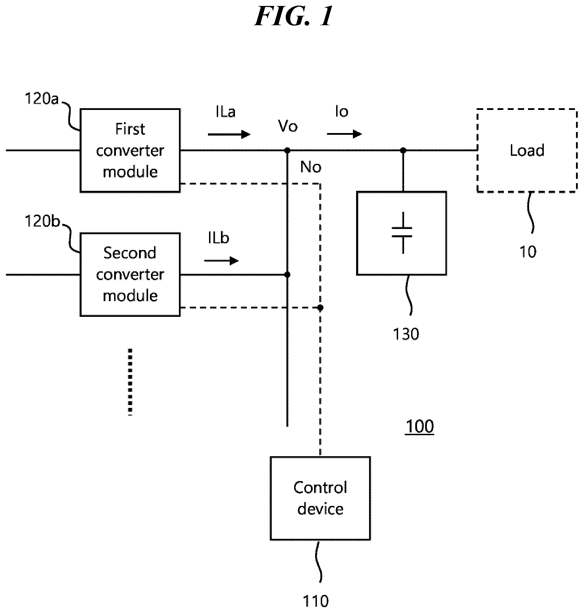

FIG. 1 is a configuration diagram of a converter according to an embodiment.

Referring to FIG. 1, a converter 100 may comprise multiple converter modules 120a, 120b.

Each of the converter modules 120a, 120b may include passive elements, such as switching elements, inductors, or the like. Each of the converter modules 120a, 120b may convert electric power by controlling turn-ons/turn-offs of switching elements. Each of the converter modules 120a, 120b may include a power stage to convert alternative currents (AC) into direct currents (DC) or a power stage to convert DC into DC. Otherwise, each of the converter modules 120a, 120b may include a power stage to convert AC into AC.

Each of the converter modules 120a, 120b may include a power stage of, for example, a buck converter type. In this case, each of the converter modules 120a, 120b may include a first switching element connected to an input side and a second switching element connected to the ground, and may convert electric power by alternately turning on/off the first switching element and the second switching element. Each of the converter modules 120a, 120b may include a power stage of a boost converter type or a power stage of a buck-boost converter type.

Each of the converter modules 120a, 120b may include a transformer. Each of the converter modules 120a, 120b may rise or fall a voltage using the transformer.

Each of the converter modules 120a, 120b may include an inductor. Each of the converter modules 120a, 120b may accumulate electric energy by applying positive voltages at both ends of the inductor and supply the accumulated electric energy to an output node No.

**[0043]** The converter modules 120a, 120b may share a common output node No. The converter modules 120a, 120b may output inductor currents ILa, ILb through the common output node No. Depending on a topology of a power stage, the inductor currents ILa, ILb may be outputted through the common output node No throughout a switching period or during a predetermined time section of the switching period.

The inductor currents ILa, ILb may have waveforms that rise and then fall. Because of such waveforms, a current and/or a voltage in the common output node No may have ripples. In order to reduce the magnitude of the ripples, the converter modules 120a, 120b may be subjected to interleaving control.

The converter 100 may include a control device 110.

The control device 110 may control the converter modules 120a, 120b. The control device 110 may control switching frequencies of the converter modules 120a, 120b. The control device 110 may transmit reference signals for determining the switching frequencies to the converter modules 120a, 120b and may also transmit switching frequency values to the converter modules 120a, 120b, through communication.

The converter 100 may include an output element 130. The output element 130 may be connected to the common output node No. The output element 130 may stabilize output voltages Vo formed in the common output node No and output currents Io flowing to a load 10, or may perform temporal storage of electric energy.

The output element 130 may include a capacitor. In a case when the load 10 is another type of converter, the output element 130 may include a DC link capacitor.

In a converter 100, an element, which rapidly deteriorates and causes failures due to the deterioration, may be a capacitor. A capacitor includes a resistance component and a reactance component, which is mainly a capacitance component. When the resistance component increases due to the deterioration, ripples of a voltage formed in the capacitor may increase, and when the capacitance component decreases, there might be a problem in a function of temporarily storing electric energy.

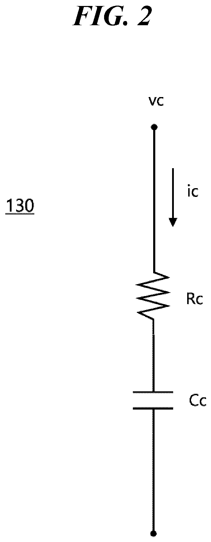

FIG. 2 is an equivalent circuit diagram of an output element according to an embodiment.

Referring to FIG. 2, the output element 130 may be equivalently modeled to be a resistance component Rc and a capacitance component Cc connected in series.

**[Equation 1]**

$$Zc = \left(\frac{1}{j\omega Cc} + Rc\right)$$

$$|Zc| = \sqrt{Rc^2 + \left(-\frac{1}{2\pi f Cc}\right)^2}$$

$$\alpha° = tan^{-1}\left(-\frac{1}{Rc \cdot 2\pi f Cc}\right)$$

Zc: Impedance of output element
$\alpha$: Phase angle

In Equation 1, in a case when the frequency is very high, the phase angle $\alpha$ may approach 0 and the capacitance component may approach 0.

**[Equation 2]**

$$Rc = \frac{|vc|}{|ic|}$$

The resistance component Rc of the output element 130 may be calculated by dividing the absolute value of a high-frequency component of a voltage formed in the output element by the absolute value of a high-frequency component of a current.

**[Equation 3]**

$$Cc = \frac{1}{Rc \cdot 2\pi f \tan(|\alpha°|)}$$

When the resistance component Rc is calculated using the high-frequency components of a voltage vc and a current ic inputted into the output element 130 as in equation 2, the capacitance component Cc may be calculated using a current/voltage phase angle $\alpha$, a frequency f, and a value of the resistance component Rc.

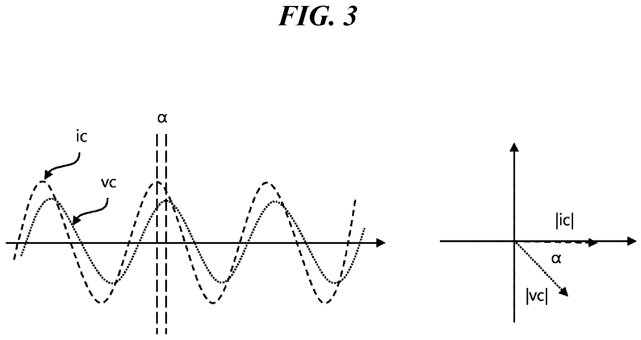

FIG. 3 is a diagram showing waveforms and a phase angle of a voltage and a current flowing into an output element according to an embodiment.

Referring to FIG. 3, a phase angle $\alpha$ may be formed between a current ic and a voltage vc by the reactance component of the output element.

As described above, the phase angle $\alpha$ approaches 0 at a high frequency and the magnitude of the phase angle $\alpha$ is clearly shown at a low frequency.

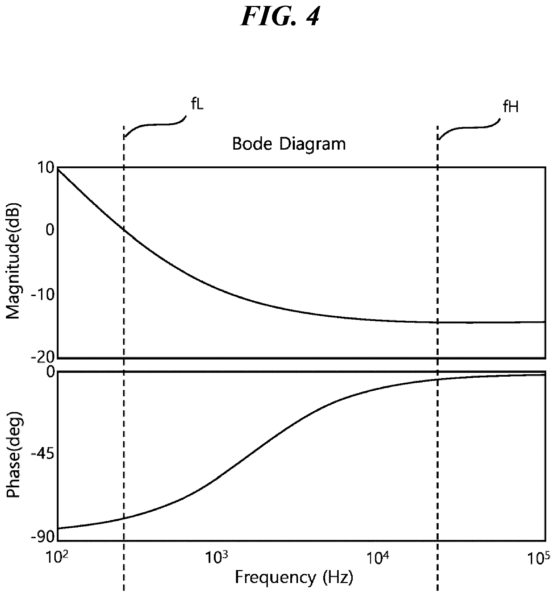

FIG. 4 is a bode diagram of an output element according to an embodiment.

Referring to FIG. 4, it can be noted that the phase angle converges 0 at a high frequency fH and has a value greater than 45 at a low frequency.

Generally, a converter uses a high frequency as a switching frequency. For example, a converter may use a frequency equal to or higher than 50KHz as a switching frequency.

When the switching frequency is 50KHz, ripple currents corresponding to the switching frequency may be formed by the switching frequency in both an inductor current and an output current, and the ripple currents having such a high-frequency component may be transmitted to the output element.

The control device of the converter may observe high-frequency components of currents/voltages formed in the output element and estimate a resistance component of the output element. In this way, the control device may estimate impedance of the output element, and the control device may be referred to as a device for estimating impedance of an output element in this aspect. For the convenience of description, the control device is referred to as the device for estimating impedance of an output element hereinafter.

In order to calculate the reactance component of the output element, a current of a low-frequency component needs to be applied to the output element.

In order to apply a current of a low-frequency component to the output element, the device for estimating impedance of the output element may have a current of a beat frequency formed in the output element.

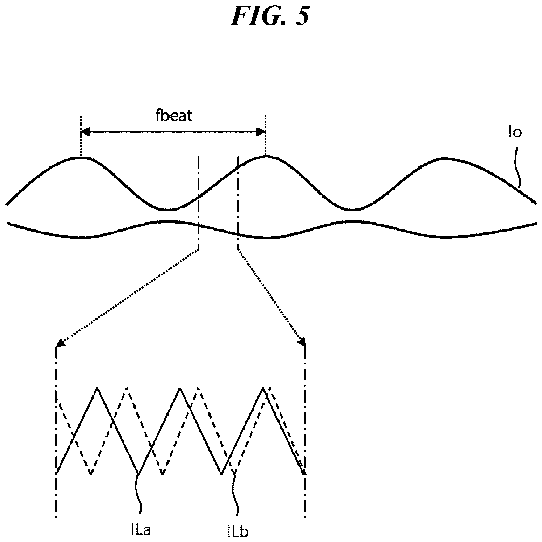

FIG. 5 is a diagram showing beat frequency waveforms shown in an output current of a converter according to an embodiment.

Referring to FIG. 5, it can be noted that a beat frequency is shown in an output current Io.

A beat frequency is formed by a difference in frequencies of signals when the signals having different frequencies are combined.

A converter comprises multiple converter modules and the converter modules output inductor currents ILa, ILb through a common output node. When the inductor currents ILa, ILb have different frequencies, a beat frequency fbeat component may appear in an output current Io.

The device for estimating impedance of an output element according to an embodiment may control switching frequencies of converter modules such that the switching frequencies of the converter modules are different from each other. Otherwise, the switching frequencies of the respective converter modules may be different by different setups.

By such controls, an output current Io may include high-frequency components by natural frequencies - switching frequencies - of the respective inductor currents ILa, ILb and a low-frequency component by beat frequencies.

For example, in a case when a switching frequency of a first converter module is 50KHz and a switching frequency of a second converter module is 49KHz, an output current Io may include a 50KHz component, a 49KHz component, and a 1KHz component, which is a beat frequency, corresponding to a difference between the two switching frequencies.

The device for estimating impedance of an output element may calculate the resistance component of the output element using a high-frequency component, corresponding to the switching frequency of the first converter module or the second converter module, from a current measurement value and a voltage measurement value of the output element.

The device for estimating impedance of an output element may also calculate the reactance component of the output element using a component corresponding to a beat frequency, which corresponds to a difference between the switching frequency of the first converter module and the switching frequency of the second converter module.

The device for estimating impedance of an output element may control the switching frequencies of the respective converter modules such that the beat frequency is less than 1/10 of each of the switching frequencies. For example, the device for estimating impedance of an output element may control the beat frequency is 1KHz by setting the switching frequency of the first converter module to be 50KHz and the switching frequency of the second converter module to be 49KHz. For another example, the device for estimating impedance of an output element may control the beat frequency is 4KHz by setting the switching frequency of the first converter module to be 50KHz and the switching frequency of the second converter module to be 46KHz.

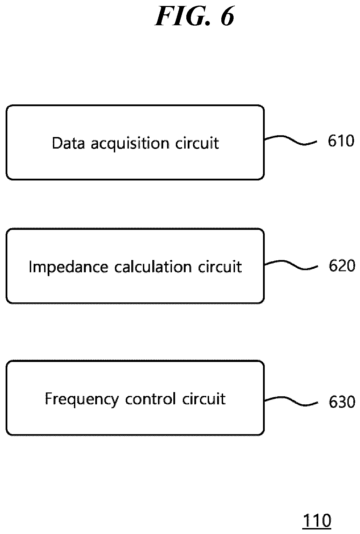

FIG. 6 is a configuration diagram of a device for estimating impedance of an output element of a converter according to an embodiment.

Referring to FIG. 6, a device for estimating impedance of an output element 110 (an estimation device, hereinafter) may comprise a data acquisition circuit 610, an impedance calculation circuit 620, and a frequency control circuit 630.

The data acquisition circuit 610 may acquire measurement data for currents and voltages of the output element connected to the common output node of the first converter module and the second converter module.

The data acquisition circuit 610 may include a sensing circuit. The data acquisition circuit 610 may directly generate current measurement values and voltage measurement values of the output element through the sensing circuit.

The data acquisition circuit 610 may include a communication circuit. The data acquisition circuit 610 may receive current measurement values and voltage measurement values of the output element from other devices through the communication circuit.

The impedance calculation circuit 620 may calculate impedance of the output element using the current measurement values and the voltage measurement values.

The impedance calculation circuit 620 may calculate a resistance component of the output element using one high-frequency component of the current measurement values and one high-frequency component of the voltage measurement values.

The impedance calculation circuit 620 may also calculate a reactance component of the output element using one low-frequency component of the current measurement values and one low-frequency component of the voltage measurement values.

The one high-frequency component may be a component, for example, corresponding to the switching frequency of one of the multiple converter modules. The impedance calculation circuit 620 may extract a component corresponding to the switching frequency of a converter module from the current measurement values and the voltage measurement values and calculate the resistance component of the output element using the component.

For another example of the one high-frequency component, the impedance calculation circuit 620 may extract components corresponding to a frequency, which is N times (N is a natural number equal to or greater than 2) the switching frequency, to calculate the resistance component of the output element. In a case when two or more among the multiple converter modules are subjected to interleaving control, components corresponding to a frequency, which is N times the switching frequency, may appear in the output element. The impedance calculation circuit 620 may extract such components from the current measurement values and the voltage measurement values and calculate the resistance component of the output element.

The one low-frequency component may be, for example, a beat frequency component. The impedance calculation circuit 620 may calculate the reactance component of the output element using a component corresponding to a beat frequency, which corresponds to a difference between the switching frequency of the first converter module and the switching frequency of the second converter module. In a case when the output element includes a capacitance component, the impedance calculation circuit 620 may calculate the capacitance component using a component corresponding to a beat frequency from the current measurement values and the voltage measurement values.

There may be various methods for extracting a high-frequency component and a low-frequency component from the current measurement values and the voltage measurement values.

For example, the impedance calculation circuit 620 may apply Fast Fourier Transform (FFT) to the current measurement values and the voltage measurement values and extract a high-frequency component and a low-frequency component from the results of the FFT.

For another example, the impedance calculation circuit 620 may extract a high-frequency component from the current measurement values and the voltage measurement values using a high-frequency band pass filter. The impedance calculation circuit 620 may also extract a low-frequency component from the current measurement values and the voltage measurement values using a low-frequency band pass filter.

The center frequency of the high-frequency band pass filter may be the switching frequency of the first converter module or the switching frequency of the second converter module.

The center frequency of the low-frequency band pass filter may be the beat frequency.

The impedance calculation circuit 620 may identify the magnitude of a current or a voltage and a current/voltage phase angle from the extracted high-frequency component.

When the current/voltage phase angle is within a predetermined range, the impedance calculation circuit 620 may calculate the resistance component of the output element, and when the current/voltage phase angle is out of the predetermined range, the impedance calculation circuit 620 may not calculate the resistance component of the output element.

For example, when the impedance calculation circuit 620 has extracted a 50KHz component, which corresponds to the switching frequency of the first converter module, from the current measurement values and the voltage measurement values and the phase angle is out of a predetermined range (for example, a range of $\pm 5$ degrees), the impedance calculation circuit 620 may not calculate the resistance component using the extracted value.

In this case, the impedance calculation circuit 620 may additionally extract a component regarding the switching frequency of another converter module. When the phase angle of this component is verified to be within a predetermined range, the resistance component may be calculated using this component.

The frequency control circuit 630 may control the switching frequencies of the respective converter modules.

The frequency control circuit 630 may control the switching frequencies of the respective converter modules to be practically identical in a first mode.

The frequency control circuit 630 may also perform interleaving control for the respective converter modules in the first mode. In a case when there are two converter modules, the frequency control circuits 630 may maintain a phase difference between the converter modules to be 180 degrees.

The frequency control circuit 630 may control the switching frequencies of at least two converter modules to be different from each other in a second mode.

The impedance calculation circuit 620 may calculate impedance of the output element in the second mode.

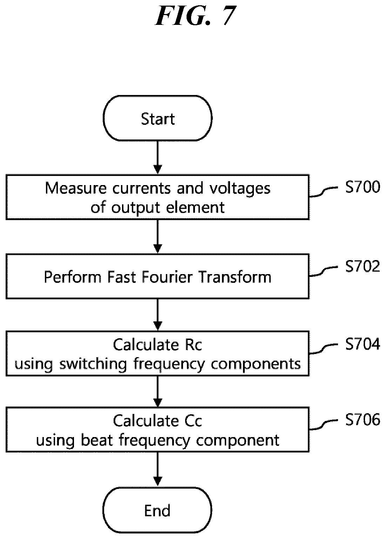

FIG. 7 is a flow diagram of a first example of a method in which a device according to an embodiment estimates impedance of an output element of a converter.

Referring to FIG. 7, the estimation device may acquire current measurement values and voltage measurement values of the output element connected to the common output node of the first converter module and the second converter module (S700).

The estimation device may generate the current measurement values and the voltage measurement values by measuring currents/voltages of the output element. Otherwise, the estimation device may receive the current measurement values and the voltage measurement values of the output element from another device.

The current measurement values and the voltage measurement values may be measured or acquired in time series. The estimation device may apply Fast Fourier Transform to the current measurement values and the voltage measurement values acquired in a predetermined time section (S702).

The estimation device may calculate the resistance component Rc of the output element using a component corresponding to the switching frequency of the first converter module from the current measurement values and the voltage measurement values (S704).

The estimation device may calculate the reactance component of the output element using a component corresponding to the beat frequency, which corresponds to a difference between the switching frequency of the first converter module and the switching frequency of the second converter module (S706).

The estimation device may calculate the resistance component Rc of the output element using a component of the switching frequency of a converter module, which is higher than the switching frequencies of other converter modules.

For example, in a case when the switching frequency of the first converter module is 50KHz and the switching frequency of the second converter module is 46KHz, the estimation device may extract a 50KHz component of the switching frequency of the first converter module from the values subjected to the Fast Fourier Transform and calculate the resistance component Rc of the output element.

In calculating the resistance component of the output element (S704), in a case when the current/voltage phase angle of a component corresponding to the switching frequency of the first converter module is within a predetermined range, the estimation device may calculate the resistance component of the output element using this component from the values subjected to the Fast Fourier Transform. However, in a case when the current/voltage phase angle of this component is out of the predetermined range, the estimation device may extract a component corresponding to the switching frequency of the second converter module from the values subjected to the Fast Fourier Transform and calculate the resistance component of the output element using this component.

In calculating the reactance component of the output element (S706), the estimation device may calculate the reactance component using the current/voltage phase angle of the component corresponding to the beat frequency and the pre-calculated resistance component.

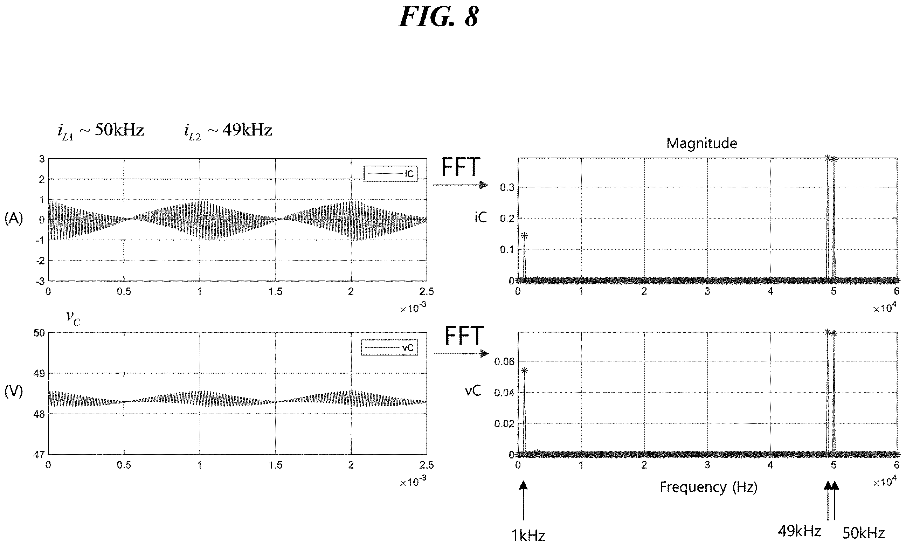

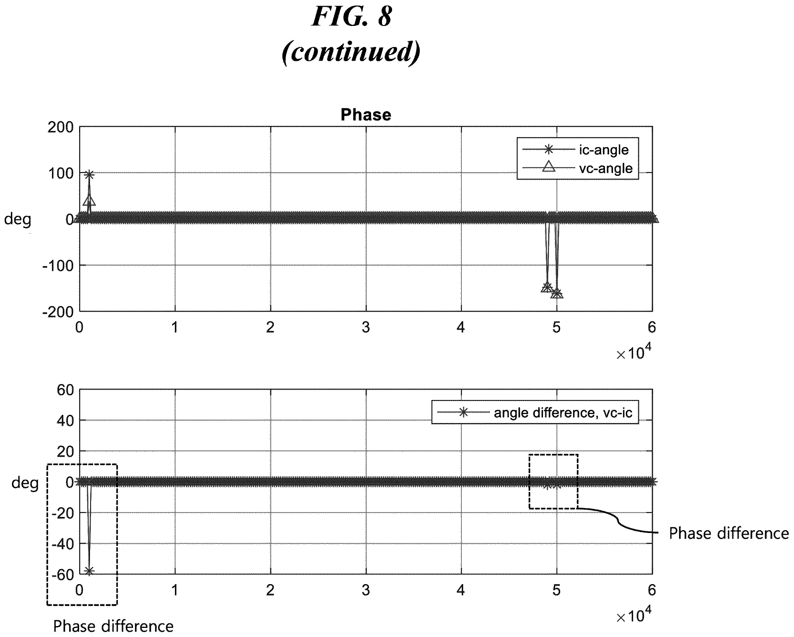

FIG. 8 is a diagram showing simulation results according to a first example.

Referring to FIG. 8, in a simulation according to a first example, the switching frequency of the first converter module is 50KHz and the switching frequency of the second converter module is 49KHz. The resistance component of the output element is 0.2ohm and the capacitance component thereof is 500uF.

In this condition, there may be a component corresponding to the beat frequency as well as a component corresponding the switching frequencies in current waveforms and voltage waveforms of the output element.

The current measurement values and the voltage measurement values are acquired for a predetermined time section, and subsequently, the Fast Fourier Transform (FFT) is performed for these values. According to the results of the FFT, the magnitude and phase of each frequency may be identified.

It may be verified that there hardly are phase differences in currents and voltages in a high-frequency component corresponding to 50KHz.

The estimation device may identify the 50KHz component of the voltage measurement values in the simulation results. The magnitude of the 50KHz component of the voltage measurement values is 0.0788 and the magnitude of the 50KHz component of the current measurement values is 0.3886.

The resistance component may be calculated by dividing the magnitude of a voltage by the magnitude of a current in the high-frequency component. According to such a calculation (0.0788/0.3886), the magnitude of the resistance component is 0.2001 ohm, which is very similar to the value originally used for the simulation.

The capacitance component may be calculated using Equation 3. In the 1KHz component corresponding to the beat frequency, the phase angle is -57.85 degrees.

According to the calculation using Equation 3, the capacitance component is 499.87uF as follows, which is very similar to the value used for the simulation.

$$Cc = \frac{1}{0.2001 \cdot 2\pi(1000)tan(|57.85|)} = 499.87uF$$

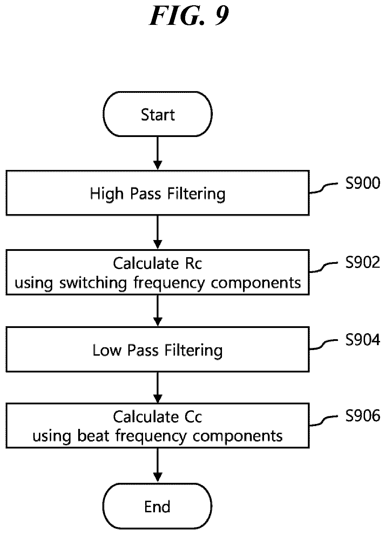

FIG. 9 is a flow diagram of a second example of a method in which a device according to an embodiment estimates impedance of an output element of a converter.

Referring to FIG. 9, the estimation device may extract one high-frequency component of the current measurement values and one high-frequency component of the voltage measurement values by making current measurement signals and voltage measurement signals of the output element, which is connected to the common output node of the first converter module and the second converter module, pass through the high-frequency band pass filter (S900).

The estimation device may calculate the resistance component of the output element using these high-frequency components (S902).

The estimation device may extract one low-frequency component of the current measurement values and one low-frequency component of the voltage measurement values by making current measurement signals and voltage measurement signals pass through the low-frequency band pass filter (S904).

The estimation device may calculate the reactance component of the output element using components corresponding to these low-frequency components (S906).

The high-frequency band pass filter may be a band pass filter letting a high-frequency band including the switching frequency of the first converter module pass through. In practice, the center frequency of the high-frequency band pass filter may be the switching frequency of the first converter module.

In a case when the first converter module and the second converter module are subjected to interleaving control, the high-frequency band pass filter may be a band pass filter letting a high-frequency band including switching frequencies formed by the interleaving control, which are N times the original switching frequencies (N is equal to or greater than 2), pass through.

The low-frequency band pass filter may be a band pass filter letting a low-frequency band including the beat frequency, corresponding to a difference between the switching frequency of the first converter module and the switching frequency of the second converter module, pass through.

In calculating the resistance component of the output element (S902), the estimation device may calculate the resistance component by dividing the absolute value of a value corresponding to one high-frequency component of the voltage measurement values by the absolute value of a value corresponding to one high-frequency component of the current measurement values.

The output element may be an output capacitor, and the estimation device may calculate the capacitance component of the output capacitor using the beat frequency in calculating the reactance component of the output element (S906).

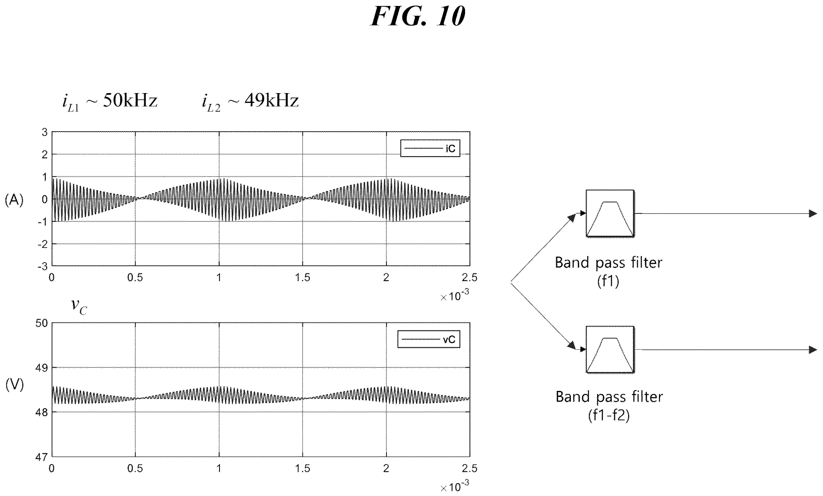

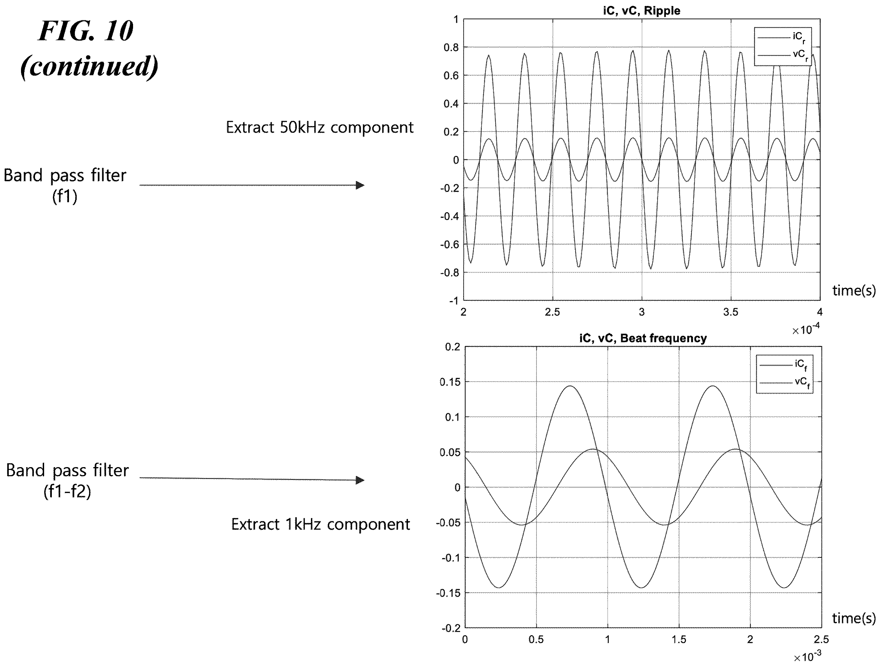

FIG. 10 is a diagram showing simulation results according to a second example.

Referring to FIG. 10, in a simulation according to the second example, the switching frequency of the first converter module is 50KHz and the switching frequency of the second converter module is 49KHz. The resistance component of the output element is 0.2ohm and the capacitance component thereof is 500uF.

In this condition, there may be a component corresponding to the beat frequency as well as a component corresponding the switching frequencies in current waveforms and voltage waveforms of the output element.

The estimation device may extract a high-frequency component from current waveforms and voltage waveforms in a time domain using a high-frequency band pass filter having the switching frequency fl of the first converter module as the center frequency.

The estimation device may extract a low-frequency component from the current waveforms and the voltage waveforms in the time domain using a low-frequency band pass filter having, as the center frequency, the beat frequency f1-f2 corresponding to a difference between the switching frequency fl of the first converter module and the switching frequency f2 of the second converter module.

The estimation device may calculate the resistance component of the output element using a magnitude value of the high-frequency component.

In addition, the estimation device may calculate the capacitance component of the output element using the previously calculated resistance component, the magnitude of the low-frequency component, and the phase angle.

During describing the present embodiment, an exemplary method, in which the resistance component of the output element is calculated using the switching frequency of one converter module, is described. However, the present disclosure is not limited to such an exemplary method.

If the switching frequency is not sufficiently high, equations such as equation 1 or equation 3 may be derived regarding the switching frequency component as well. Since the estimation device may identify phase angles respectively from the switching frequency and the beat frequency, there are two unknowns (Rc, Cc) and two equations and this leads to solving equations.

Accordingly, in addition to the above-described descriptions, a method for estimating impedance of the output element using the switching frequency of one converter module and the beat frequency of two converter modules may also be applied to the present disclosure.

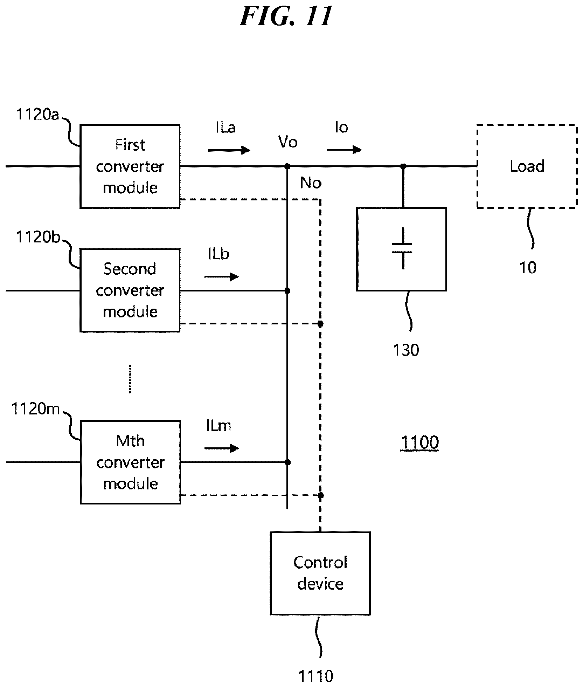

FIG. 11 is a configuration diagram of a converter according to another embodiment.

Referring to FIG. 11, a converter 1100 may comprise M (M is a natural number equal to or greater than 3) converter modules 1120a, 1120b, ..., 1120m.

Each of the converter modules 1120a, 1120b, ..., 1120m may have the same configuration and operational characteristics as those of the converter modules (120a, 120b in FIG. 1) described with reference to FIG. 1. For example, each of the converter modules 1120a, 1120b, ..., 1120m may include switching elements and passive elements, such as inductors. Each of the converter modules 1120a, 1120b, ..., 1120m may convert electric power by controlling turn-ons/turn-offs of the switching elements. Each of the converter modules 1120a, 1120b, ..., 1120m may include a power stage to convert alternative currents (AC) into direct currents (DC) or a power stage to convert DC into DC. Otherwise, each of the converter modules 1120a, 1120b, ..., 1120m may include a power stage to convert AC into AC. All the configurations and operational characteristics of the converter modules (120a, 120b in FIG. 1) described with reference to FIG. 1 may be applied to the converter modules 1120a, 1120b, ..., 1120m as well, which are described with reference to FIG. 11.

The converter modules 1120a, 1120b, ..., 1120m may share a common output node No. The converter modules 1120a, 1120b, ..., 1120m may output inductor currents ILa, ILb, ..., ILm through the common output node No. Depending on a topology of a power stage, the inductor currents ILa, ILb, ..., ILm may be outputted through the common output node No throughout a switching period or during a predetermined time section of the switching period.

The inductor currents ILa, ILb, ..., ILm may have waveforms that rise and then fall. Because of such waveforms, a current and/or a voltage in the common output node No may have ripples. In order to reduce the magnitude of the ripples, the converter modules 1120a, 1120b, ..., 1120m may be subjected to interleaving control.

The converter 1100 may include a control device 1110.

The control device 1110 may control the converter modules 1120a, 1120b, ..., 1120m. The control device 1110 may control switching frequencies of the converter modules 1120a, 1120b, ..., 1120m. The control device 1110 may transmit reference signals for determining the switching frequencies to the converter modules 1120a, 1120b, ..., 1120m and may also transmit switching frequency values to the converter modules 1120a, 1120b, ..., 1120m, through communication.

The converter 1100 may include an output element 130. The output element 130 may be connected to the common output node No. The output element 130 may stabilize output voltages Vo formed in the common output node No and output currents Io flowing to a load 10, or may perform temporal storage of electric energy.

The output element 130 may include a capacitor. In a case when the load 10 is another type of converter, the output element 130 may include a DC link capacitor.

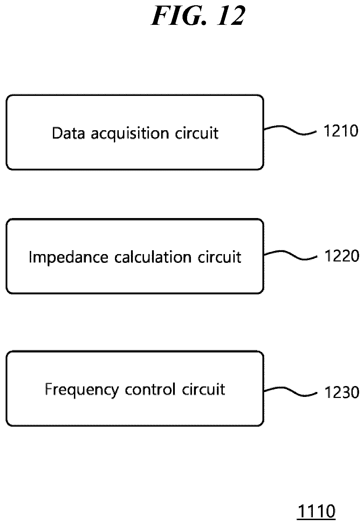

FIG. 12 is a configuration diagram of a device for estimating impedance of an output element of a converter according to another embodiment.

Referring to FIG. 12, a device for estimating impedance of an output element 1110 (an estimation device, hereinafter) may comprise a data acquisition circuit 1210, an impedance calculation circuit 1220, and a frequency control circuit 1230.

The data acquisition circuit 1210 may acquire measurement data for currents and voltages of the output element connected to the common output node of the converter modules.

The data acquisition circuit 1210 may include a sensing circuit. The data acquisition circuit 1210 may directly generate current measurement values and voltage measurement values of the output element through the sensing circuit.

The data acquisition circuit 1210 may include a communication circuit. The data acquisition circuit 1210 may receive current measurement values and voltage measurement values of the output element from other devices through the communication circuit.

The impedance calculation circuit 1220 may calculate impedance of the output element using the current measurement values and the voltage measurement values.

The impedance calculation circuit 1220 may calculate a resistance component of the output element using one high-frequency component of the current measurement values and one high-frequency component of the voltage measurement values.

The impedance calculation circuit 1220 may also calculate a reactance component of the output element using one low-frequency component of the current measurement values and one low-frequency component of the voltage measurement values.

There may be various frequency components in the current measurement values and the voltage measurement values. For example, there may be switching frequency components corresponding to switching frequencies of the respective converter modules in the current measurement values and the voltage measurement values. In addition, there may also be beat frequency components generated by differences of switching frequencies of two or more converter modules in the current measurement values and the voltage measurement values.

The switching frequency components may correspond to relatively high frequencies compared to the beat frequency components and the beat frequency components may correspond to relatively low frequencies. However, depending on embodiments, some of the switching frequency components may correspond to relatively low frequencies and some of the beat frequency components may correspond to relatively high frequencies.

Also, the switching frequency components may include high-frequency components of the switching frequencies as well as the components corresponding to the switching frequencies of the respective converter modules.

The impedance calculation circuit 1220 may calculate impedance of the output element using at least two components among the switching frequency components and the beat frequency components. For example, the impedance calculation circuit 1220 may calculate the resistance component of the output element using one high-frequency component among the switching frequency components and the beat frequency components. The impedance calculation circuit 1220 may also calculate the reactance component (for example, the capacitance component) of the output element using one low-frequency component among the switching frequency components and the beat frequency components.

The impedance calculation circuit 1220 may calculate the resistance component of the output element using one of the switching frequency components and calculate the reactance component of the output element using one of the beat frequency components.

The beat frequency components may be generated by differences between the switching frequencies of two or more converter modules. For example, in a case when there are three converter modules, there may appear various combinations of beat frequency components in the current measurement values and the voltage measurement values, such as a beat frequency by a difference between switching frequencies of a first converter module and a second converter module, a beat frequency by a difference between switching frequencies of the second converter module and a third converter module, a beat frequency by a difference between switching frequencies of the third converter module and the first converter module, and a beat frequency by a difference among switching frequencies of the first converter module, second converter module, and third converter module.

The impedance calculation circuit 1220 may identify beat frequency components, by which the reactance component of the output element can be best identified, among the beat frequency components by using a predetermined algorithm or repetitions of trials and errors.

There may be various methods for extracting high-frequency components and low-frequency components from the current measurement values and the voltage measurement values.

For example, the impedance calculation circuit 1220 may apply Fast Fourier Transform (FFT) to the current measurement values and the voltage measurement values and extract high-frequency components and low-frequency components from the results of the FFT.

For another example, the impedance calculation circuit 1220 may extract high-frequency components from the current measurement values and the voltage measurement values using a high-frequency band pass filter. The impedance calculation circuit 1220 may also extract low-frequency components from the current measurement values and the voltage measurement values using a low-frequency band pass filter.

The center frequency of the high-frequency band pass filter may be the switching frequency of the first converter module or the switching frequency of the second converter module.

Here, the configurations and operational characteristics of the impedance calculation circuit (620 in FIG. 6) described with reference to FIG. 6 may be applied to the impedance calculation circuit 1220 as well, which are described with reference to FIG. 12.

The frequency control circuit 1230 may control the switching frequencies of the respective converter modules.

The frequency control circuit 1230 may control the switching frequencies of the respective converter modules to be practically identical in a first mode.

The frequency control circuit 1230 may also perform interleaving control for the respective converter modules in the first mode. In a case when there are M converter modules, the frequency control circuits 1230 may maintain a phase difference between the converter modules to be (360/M) degrees.

The frequency control circuit 1230 may control the switching frequencies of at least two converter modules to be different from each other in a second mode.

The impedance calculation circuit 1220 may calculate impedance of the output element in this second mode.

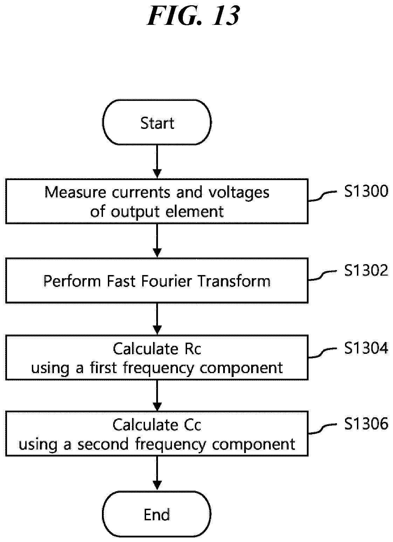

FIG. 13 is a flow diagram of a first example of a method in which a device according to another embodiment estimates impedance of an output element of a converter.

Referring to FIG. 13, the estimation device may acquire current measurement values and voltage measurement values of the output element connected to the common output node of M converter modules (S1300).

The estimation device may generate the current measurement values and the voltage measurement values by measuring currents/voltages of the output element. Otherwise, the estimation device may receive the current measurement values and the voltage measurement values of the output element from another device.

The current measurement values and the voltage measurement values may be measured or acquired in time series. The estimation device may apply Fast Fourier Transform to the current measurement values and the voltage measurement values acquired in a predetermined time section (S1302).

The estimation device may calculate the resistance component Rc of the output element using a first frequency component corresponding to a relatively high frequency among switching frequency components and beat frequency components from the current measurement values and the voltage measurement values (S1304).

The estimation device may calculate the reactance component of the output element using a second frequency component corresponding to a relatively low frequency among the switching frequency components and the beat frequency components from the current measurement values and the voltage measurement values (S1306).

The estimation device may calculate the resistance component Rc of the output element using a component of the switching frequency of a converter module, which is higher than the switching frequencies of other converter modules.

In calculating the resistance component of the output element (S1304), in a case when the current/voltage phase angle of the first frequency component is within a predetermined range, the estimation device may calculate the resistance component of the output element using this component from the values subjected to the Fast Fourier Transform. However, in a case when the current/voltage phase angle of this component is out of the predetermined range, the estimation device may extract another component from the values subjected to the Fast Fourier Transform and calculate the resistance component of the output element using that component.

In calculating the reactance component of the output element (S1306), the estimation device may calculate the reactance component using the current/voltage phase angle of the second frequency component and the pre-calculated resistance component.

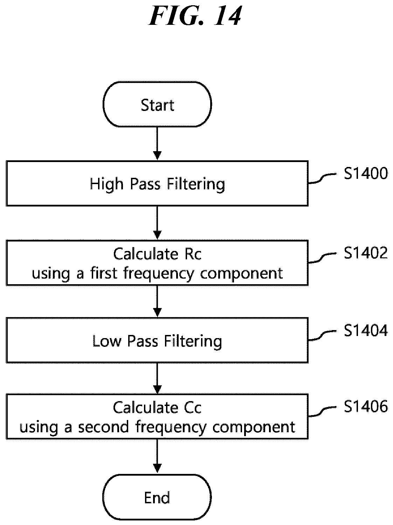

FIG. 14 is a flow diagram of a second example of a method in which a device according to another embodiment estimates impedance of an output element of a converter.

Referring to FIG. 14, the estimation device may extract one high-frequency component of the current measurement values and one high-frequency component of the voltage measurement values by making current measurement signals and voltage measurement signals of the output element, which is connected to the common output node of the M converter modules, pass through the high-frequency band pass filter (S1400).

The estimation device may calculate the resistance component of the output element using these high-frequency components (S1402).

The estimation device may extract one low-frequency component of the current measurement values and one low-frequency component of the voltage measurement values by making current measurement signals and voltage measurement signals pass through the low-frequency band pass filter (S1404).

The estimation device may calculate the reactance component of the output element using components corresponding to these low-frequency components (S1406).

The high-frequency band pass filter may be a band pass filter letting a high-frequency band including switching frequencies of the converter modules pass through.

In a case when the converter modules are subjected to interleaving control, the high-frequency band pass filter may be a band pass filter letting a high-frequency band, including switching frequencies formed by the interleaving control, which are N times the original switching frequencies (N is equal to or greater than 2), pass through.

The low-frequency band pass filter may be a band pass filter letting a low-frequency band including beat frequencies corresponding to differences among the switching frequencies of the converter modules.

In calculating the resistance component of the output element (S1402), the estimation device may calculate the resistance component by dividing the absolute value of a value corresponding to one high-frequency component of the voltage measurement values by the absolute value of a value corresponding to one high-frequency component of the current measurement values.

The output element may be an output capacitor, and the estimation device may calculate a capacitance component of the output capacitor using the beat frequencies in calculating the reactance component of the output element (S1406).

As described above, the present disclosure enables estimating characteristics of converter elements. The present disclosure also enables estimating impedance of converter elements. In addition, the present disclosure enables estimating impedance of a converter output element.

Since terms, such as "including," "comprising," and "having" mean that corresponding elements may exist unless they are specifically described to the contrary, it should be construed that other elements can be additionally included, rather than that such elements are excluded. All technical, scientific, or other terms are used consistently with the meanings as understood by a person skilled in the art unless defined to the contrary. Common terms as found in dictionaries should be interpreted in the context of the related technical writings, rather than overly ideally or impractically, unless the present disclosure expressly defines them so.

Although example embodiments of the present disclosure have been described for illustrative purposes, those having ordinary skill in the art should appreciate that various modifications, additions, and substitutions are possible without departing from the scope and spirit of the present disclosure. Therefore, the embodiments described in the present disclosure are intended to illustrate the scope of the technical idea of the present disclosure, and the scope of the present disclosure is not limited by the described embodiments. The scope of the present disclosure should be construed on the basis of the accompanying claims in such a manner that all of the technical ideas included within the scope equivalent to the claims are included in the present disclosure.

*This work was supported by the Korea Institute of Energy Technology Evaluation and Planning (KETEP) and the Ministry of Trade, Industry & Energy (MOTIE) of the Republic of Korea (RS-2023-00234707, Development of grid-connected operation and control techniques of fuel-cell and water electrolysis for power grid stabilization).*

**Claims**

1. A device for estimating impedance of an output element comprising:

   a data acquisition circuit to acquire measurement data for currents and voltages of the output element connected to a common output node of a first converter module and a second converter module; and
   an impedance calculation circuit to calculate impedance of the output element using a component corresponding to a switching frequency of the first converter module and a component corresponding to a beat frequency, which corresponds to a difference between the switching frequency of the first converter module and a switching frequency of the second converter module, from current measurement values and voltage measurement values of the output element.

2. The device of claim 1, wherein the impedance calculation circuit calculates a resistance component of the output element using the component corresponding to the switching frequency of the first converter module and calculates a reactance component of the output element using the component corresponding to the beat frequency.

3. The device of claim 2, wherein the impedance calculation circuit calculates the reactance component using a current/voltage phase angle of the component corresponding to the beat frequency and the pre-calculated resistance component.

4. The device of any one of claims 1 to 3,

   further including a frequency control circuit capable of transmitting switching frequency control signals to the first converter module and the second converter module,
   wherein the frequency control circuit controls the switching frequencies of the first converter module and the second converter module to be identical in a first mode and controls the switching frequencies thereof to be different in a second mode, and
   wherein the impedance calculation circuit calculates the reactance component of the output element in the second mode.

**5.** The device of any one of claims 1 to 4,

wherein the output element is an output capacitor, and
wherein the impedance calculation circuit calculates a capacitance component of the output capacitor using the beat frequency.

**6.** A method for estimating impedance of an output element comprising operations or steps of:

acquiring current measurement values and voltage measurement values of the output element connected to a common output node of a first converter module and a second converter module;
performing Fast Fourier Transform with respect to the current measurement values and the voltage measurement values;
calculating a resistance component of the output element using a component corresponding to a switching frequency of the first converter module from the current measurement values and the voltage measurement values; and
calculating a reactance component of the output element using the switching frequency of the first converter module and a component corresponding to a beat frequency, which corresponds to a difference between the switching frequency of the first converter module and a switching frequency of the second converter module, from the current measurement values and the voltage measurement values.

**7.** The method of claim 6, wherein the switching frequency of the first converter module is higher than the switching frequency of the second converter module.

**8.** The method of claim 6 or 7, wherein, in calculating the resistance component of the output element, in a case when a current/voltage phase angle of the component corresponding to the switching frequency of the first converter module is within a predetermined range, the resistance component of the output element is calculated.

**9.** A method for estimating impedance of an output element comprising operations or steps of:

extracting one high-frequency component of current measurement values and one high-frequency component of voltage measurement values by making current measurement signals and voltage measurement signals of the output element, which is connected to a common output node of a first converter module and a second converter module, pass through a high-frequency band pass filter;
calculating a resistance component of the output element using the high-frequency components;
extracting one low-frequency component of the current measurement values and one low-frequency component of voltage measurement values by making the current measurement signals and voltage measurement signals pass through a low-frequency band pass filter; and
calculating a reactance component of the output element using components corresponding to the low-frequency components.

**10.** The method of claim 9, wherein the high-frequency band pass filter is a band pass filter letting a high-frequency band including the switching frequency of the first converter module pass through.

**11.** The method of claim 9 or 10, wherein the low-frequency band pass filter is a band pass filter letting a low-frequency band including the beat frequency, corresponding to a difference between the switching frequency of the first converter module and the switching frequency of the second converter module, pass through.

**12.** The method of any one of claims 9 to 11, wherein, in calculating the resistance component of the output element, the resistance component is calculated by dividing the absolute value of a value corresponding to one high-frequency component of the voltage measurement values by the absolute value of a value corresponding to one high-frequency component of the current measurement values.

**13.** The method of any one of claims 9 to 12,

wherein the first converter module and the second converter module are subjected to interleaving control, and
wherein the high-frequency band pass filter is a band pass filter letting a high-frequency band including switching frequencies formed by the interleaving control, which are N times the original switching frequencies (N is equal to or greater than 2), pass through.

**14.** A device for estimating impedance of an output element comprising:

a data acquisition circuit to acquire measurement data for currents and voltages of the output element connected to a common output node of at least three converter modules; and

an impedance calculation circuit to calculate impedance of the output element using at least two components among switching frequency components corresponding to switching frequencies of the respective converter modules and beat frequency components generated by differences between switching frequencies of two or more converter modules from current measurement values and voltage measurement values of the output element.

**15.** The device of claim 14,

further including a frequency control circuit capable of transmitting switching frequency control signals to the at least three converter modules,

wherein the frequency control circuit may control the switching frequencies of the at least three converter modules to be identical in a first mode and control the switching frequencies of at least two of the at least three converter modules to be different in a second mode, and

wherein the impedance calculation circuit calculates a reactance component of the output element in the second mode.

**FIG. 1**

*FIG. 2*

130

vc

ic

Rc

Cc

# FIG. 3

# FIG. 4

## FIG. 5

## FIG. 6

Data acquisition circuit — 610

Impedance calculation circuit — 620

Frequency control circuit — 630

110

# FIG. 7

```
            ┌─────────────┐
            │    Start    │
            └──────┬──────┘
                   │
                   ▼
   ┌───────────────────────────────┐
   │   Measure currents and voltages │──── S700
   │        of output element        │
   └───────────────┬───────────────┘
                   │
                   ▼
   ┌───────────────────────────────┐
   │   Perform Fast Fourier Transform │──── S702
   └───────────────┬───────────────┘
                   │
                   ▼
   ┌───────────────────────────────┐
   │          Calculate Rc           │──── S704
   │  using switching frequency components │
   └───────────────┬───────────────┘
                   │
                   ▼
   ┌───────────────────────────────┐
   │          Calculate Cc           │──── S706
   │   using beat frequency component  │
   └───────────────┬───────────────┘
                   │
                   ▼
            ┌─────────────┐
            │     End     │
            └─────────────┘
```

*FIG. 8*

*FIG. 8*
*(continued)*

# FIG. 9

```
                    ┌──────────┐
                    │   Start  │
                    └────┬─────┘
                         │
                         ▼
    ┌─────────────────────────────────┐
    │       High Pass Filtering       │ ── S900
    └────────────────┬────────────────┘
                     │
                     ▼
    ┌─────────────────────────────────┐
    │         Calculate Rc            │ ── S902
    │ using switching frequency components │
    └────────────────┬────────────────┘
                     │
                     ▼
    ┌─────────────────────────────────┐
    │       Low Pass Filtering        │ ── S904
    └────────────────┬────────────────┘
                     │
                     ▼
    ┌─────────────────────────────────┐
    │         Calculate Cc            │ ── S906
    │   using beat frequency components   │
    └────────────────┬────────────────┘
                     │
                     ▼
                ┌─────────┐
                │   End   │
                └─────────┘
```

## *FIG. 10*

$i_{L1} \sim 50\text{kHz} \qquad i_{L2} \sim 49\text{kHz}$

# FIG. 10
## (continued)

Extract 50kHz component

Band pass filter
(f1)

iC, vC, Ripple

time(s)

Band pass filter
(f1-f2)

Extract 1kHz component

iC, vC, Beat frequency

time(s)

## *FIG. 11*

# FIG. 12

Data acquisition circuit — 1210

Impedance calculation circuit — 1220

Frequency control circuit — 1230

1110

# FIG. 13

```
                    ┌──────────┐
                    │  Start   │
                    └────┬─────┘
                         │
                         ▼
        ┌────────────────────────────────┐
        │   Measure currents and voltages │ ──  S1300
        │        of output element        │
        └────────────────┬───────────────┘
                         │
                         ▼
        ┌────────────────────────────────┐
        │   Perform Fast Fourier Transform│ ──  S1302
        └────────────────┬───────────────┘
                         │
                         ▼
        ┌────────────────────────────────┐
        │          Calculate Rc           │ ──  S1304
        │  using a first frequency component│
        └────────────────┬───────────────┘
                         │
                         ▼
        ┌────────────────────────────────┐
        │          Calculate Cc           │ ──  S1306
        │ using a second frequency component│
        └────────────────┬───────────────┘
                         │
                         ▼
                    ┌──────────┐
                    │   End    │
                    └──────────┘
```

# FIG. 14

```
              ┌─────────────┐
              │    Start    │
              └─────────────┘
                     │
                     ▼
   ┌──────────────────────────────────┐
   │        High Pass Filtering       │ ──── S1400
   └──────────────────────────────────┘
                     │
                     ▼
   ┌──────────────────────────────────┐
   │           Calculate Rc           │ ──── S1402
   │   using a first frequency component │
   └──────────────────────────────────┘
                     │
                     ▼
   ┌──────────────────────────────────┐
   │        Low Pass Filtering        │ ──── S1404
   └──────────────────────────────────┘
                     │
                     ▼
   ┌──────────────────────────────────┐
   │           Calculate Cc           │ ──── S1406
   │  using a second frequency component │
   └──────────────────────────────────┘
                     │
                     ▼
              ┌─────────────┐
              │     End     │
              └─────────────┘
```

## EUROPEAN SEARCH REPORT

Europäisches
Patentamt

European
Patent Office

Office européen
des brevets

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | LAADJAL KHALED ET AL: "Online Condition Monitoring of Electrolytic Capacitors in DC-DC Interleaved Boost Converters, Adopting a Model-Free Predictive Controller", 2021 IEEE 15TH INTERNATIONAL CONFERENCE ON COMPATIBILITY, POWER ELECTRONICS AND POWER ENGINEERING (CPE-POWERENG), IEEE, 14 July 2021 (2021-07-14), pages 1-6, XP033957219, DOI: 10.1109/CPE-POWERENG50821.2021.9501188 [retrieved on 2021-07-28] | 1-3,5-15 | INV. H02M3/158 |
| A | * pages 2-4; figures 2,3 * ----- | 4 | |
| T | ZHAO ZHAOYANG ET AL: "An Overview of Condition Monitoring Techniques for Capacitors in DC-Link Applications", IEEE TRANSACTIONS ON POWER ELECTRONICS, INSTITUTE OF ELECTRICAL AND ELECTRONICS ENGINEERS, USA, vol. 36, no. 4, 10 September 2020 (2020-09-10), pages 3692-3716, XP011823289, ISSN: 0885-8993, DOI: 10.1109/TPEL.2020.3023469 [retrieved on 2020-12-01] * the whole document * ----- | 1-15 | |

TECHNICAL FIELDS SEARCHED (IPC)

H02M

-/--

The present search report has been drawn up for all claims

| Place of search | Date of completion of the search | Examiner |
|---|---|---|
| The Hague | 28 February 2025 | Gusia, Sorin |

EPO FORM 1503 03.82 (P04C01)

Europäisches
Patentamt

European
Patent Office

Office européen
des brevets

## EUROPEAN SEARCH REPORT

**Application Number**

EP 24 21 2295

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | LAADJAL KHALED ET AL: "Diagnosis of Electrolytic Capacitors in Three-Phase Interleaved Boost Converters Controlled by Mixed Weighted Sensitivity H[infinity] Design Control", IECON 2019 - 45TH ANNUAL CONFERENCE OF THE IEEE INDUSTRIAL ELECTRONICS SOCIETY, IEEE, vol. 1, 14 October 2019 (2019-10-14), pages 1678-1683, XP033669914, DOI: 10.1109/IECON.2019.8927086 [retrieved on 2019-12-06] * page 1678 - page 1680; figures 3,5 * | 1-15 | |

**TECHNICAL FIELDS SEARCHED (IPC)**

The present search report has been drawn up for all claims

| Place of search | Date of completion of the search | Examiner |
|---|---|---|
| The Hague | 28 February 2025 | Gusia, Sorin |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**EP 4 560 908 A1**

**Patent documents cited in the description**

- KR 1020230162904

- KR 1020240120835